Europäisches Patentamt

European Patent Office

Office européen des brevets

(11) Veröffentlichungsnummer: **0 456 868 A1**

(12) **EUROPÄISCHE PATENTANMELDUNG**

(21) Anmeldenummer: 90109385.6

(22) Anmeldetag: 17.05.90

(51) Int. Cl.⁵: **G01R 21/133**, G01R 11/21, G01R 11/23

(43) Veröffentlichungstag der Anmeldung:
**21.11.91 Patentblatt 91/47**

(84) Benannte Vertragsstaaten:
**AT CH DE DK FR GB IT LI SE**

(71) Anmelder: **SIEMENS AKTIENGESELLSCHAFT**
**Wittelsbacherplatz 2**
**W-8000 München 2(DE)**

(72) Erfinder: **Steinmüller, Günter, Dipl.-Ing. (FH)**
**Laufamhlz-Strasse 65**
**W-8500 Nürnberg(DE)**
Erfinder: **Windsheimer, Klaus, Dipl.-Ing. (FH)**
**Burgambach 24**
**W-8533 Scheinfeld(DE)**

(54) **Fehlerkompensationsanordnung für einen Elektrizitätszähler nach dem Induktionsprinzip.**

(57) Die Spannungseisen (2, 3, 4) eines Elektrizitätszählers nach dem Induktionsprinzip sind mit Hilfswicklungen (6, 7, 8) versehen, die mit einem zugeordneten Bürdenwiderstand (10, 19) einen Kompensationsstromkreis bilden. Der in diesem fließende Kompensationsstrom ($I_K$) ist in Abhängigkeit von der Fehlerkurve (1) des Elektrizitätszählers (5) von einem Steuergerät (12) derart einstellbar, daß der vom Laststrom (I) abhängige Fehler (F) kompensiert wird.

FIG 2

Die Erfindung betrifft eine Fehlerkompensationsanordnung für einen Elektrizitätszähler nach dem Induktionsprinzip entsprechend dem Oberbegriff des Patentanspruches 1.

Elektrizitätszähler dieser Art sind beispielsweise in dem Lehrbuch "Grundzüge der Zählertechnik", Julius Springer-Verlag, Berlin, 1930, Seiten 136 bis 197, beschrieben. Diese Zähler besitzen ein sogenanntes Spannungseisen mit einer Spannungsspule, an der die Netzspannung anliegt, und ein sogenanntes Stromeisen mit einer Stromspule, die vom Laststrom durchflossen ist. Beide Spulen sind auf je einem Eisenkern mit Luftspalt angeordnet und wirken auf eine drehbare, magnetisch gebremste Läuferscheibe ein, die in die Luftspalte der Spannungs- und Stromeisen eintaucht und deren magnetische Flüsse ein Drehmoment auf die Scheibe ausüben, so daß diese mit einer von der Entnahmeleistung abhängigen Drehzahl um ihre Drehachse rotiert. Die Drehzahl wird von einem Zählwerk ermittelt und zeigt unmittelbar die der Entnahmeleistung entsprechende elektrische Arbeit in kWh an.

Nun ist jeder Elektrizitätszähler der vorbeschriebenen Art mit einem charakteristischen Fehler behaftet, dessen Größe bei geringem Laststrom von der Lagerreibung der Läuferscheibe und mit steigendem Laststrom von der Größe der sogenannten Stromdämpfung bestimmt wird. Diese wesentlichen Fehlerquellen haben zur Folge, daß sich ein laststromabhängiger Fehlerverlauf einstellt, der sich mit den bisher bekannten Mitteln zwar minimieren, aber nicht vollständig beseitigen läßt.

Der Erfindung liegt die Aufgabe zugrunde, den bei einem Elektrizitätszähler der eingangs erwähnten Art auftretenden, laststromabhängigen Fehler möglichst vollständig zu kompensieren.

Diese Aufgabe wird durch die im Patentanspruch 1 angegebene Erfindung dadurch gelöst, daß die zählerspezifische Fehlerkurve in Form von laststromabhängigen Fehlerwerten dargestellt und mit Hilfe eines Steuergerätes in laststromabhängige Steuergrößen transformiert wird, die über einen Kompensationsstromkreis das auf die Läuferscheibe ausgeübte Drehmoment fehlerabhängig kompensieren.

Bei einem Mehrphasenzähler, beispielsweise einem Drehstromzähler, läßt sich die Fehlerkurvenkorrektur gemäß Patentanspruch 2 in der Weise vereinfachen, daß die Hilfswicklungen über ein Mehrphasen-Gleichrichtersystem auf einen Gleichstromkreis geschaltet sind, der als Kompensationsstromkreis dient.

In einer Weiterbildung nach Patentanspruch 3 wird die Kompensation mit digitalen Mitteln von einem Mikrocomputer als Steuergerät bewirkt, in dessen Speicher die Fehlerkurve des betreffenden Zählers in digitaler Form abgelegt wird. Dadurch besteht die Möglichkeit, ein Steuergerät in einheitlicher Hardware als Chip für alle Arten von Elektrizitätszählern nach dem Induktionsprinzip einzusetzen und die Individualisierung durch Softwareanpassung vorzunehmen.

Bei einem Elektrizitätszähler mit kombinierten elektronischen Tarifgerät ergibt sich eine besonders einfache und kostensparende Möglichkeit gemäß Patentanspruch 5 dadurch, daß der im Tarifgerät bereits vorhandene Mikrocomputer für die Fehlerkorrektur mitbenutzt wird.

Weitere vorteilhafte Aus- und Weiterbildungen sind in den übrigen Unteransprüchen gekennzeichnet.

Anhand von Ausführungsbeispielen wird die Erfindung im folgenden näher erläutert. Darin zeigen:

Fig. 1    die typische Fehlerkurve eines Elektrizitätszählers nach dem Induktionsprinzip,

Fig. 2    ein Prinzipschaltbild einer Schaltungsanordnung zur Kompensation dieses Fehlers,

Fig. 3    in Abhängigkeit von der Höhe des Bürdenwiderstandes des Kompensationsstromkreises parallel verschobene Fehlerkurven,

Fig. 4    ein Funktionsdiagramm zur Darstellung der Abhängigkeit der Fehlerkompensation von der Höhe des Kompensationsstromes,

Fig. 5    eine Fehlerkurve eines Elektrizitätszählers nach dem Induktionsprinzip ohne und mit Fehlerkompensation, und

Fig. 6    das Prinzipschaltbild eines Kompensationsstromkreises mit konstantem Bürdenwiderstand.

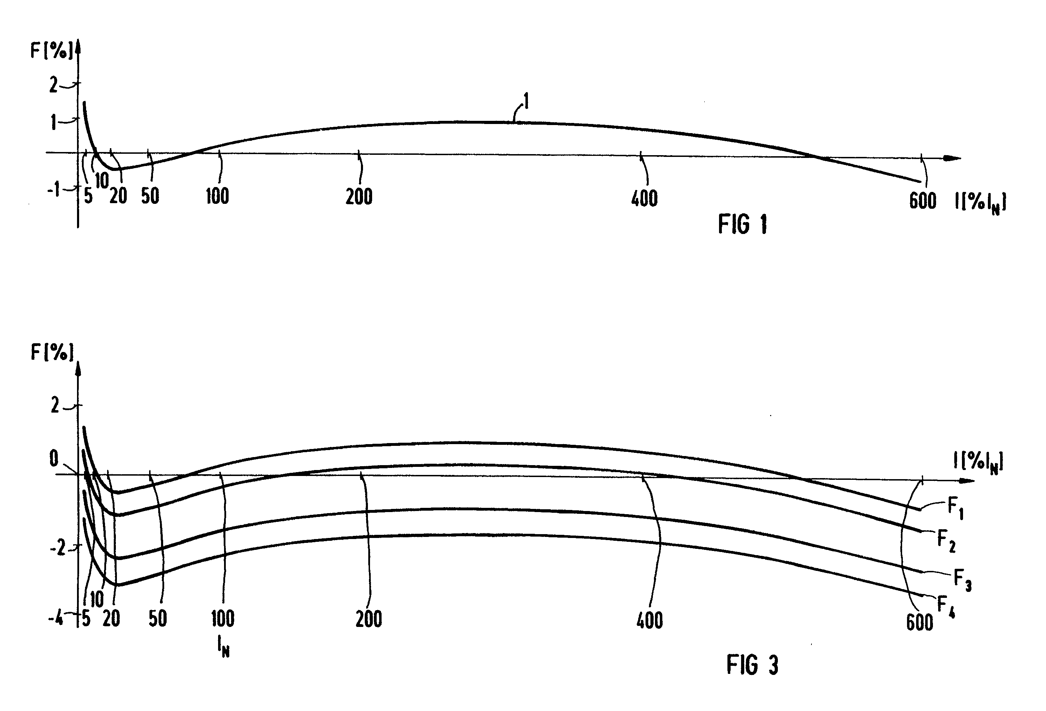

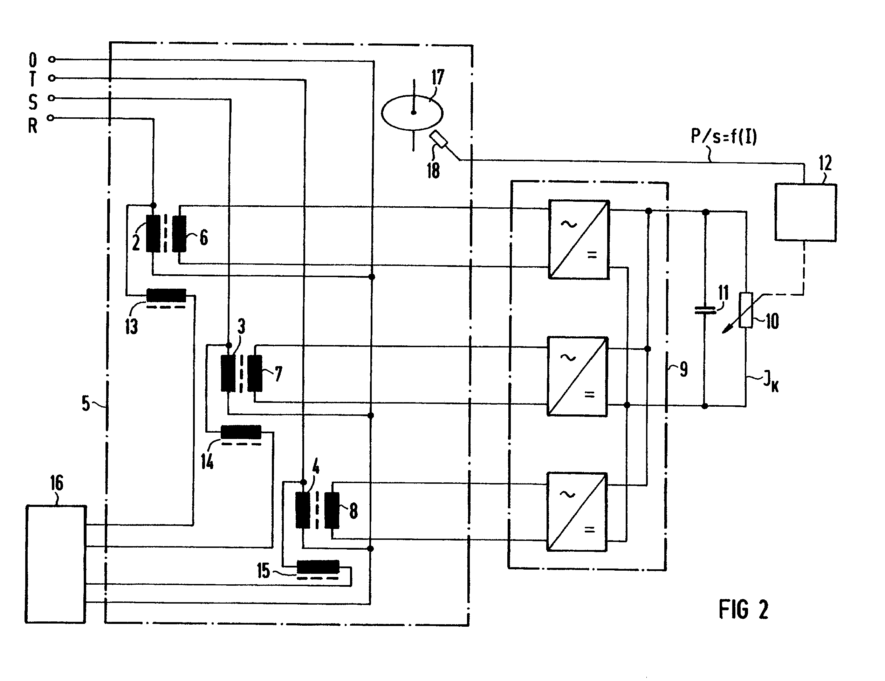

Die in Fig. 1 dargestellte typische Fehlerkurve 1 eines Elektrizitätszählers nach dem Induktionsprinzip (Ferrariszähler) zeigt den prozentualen Fehler F in Abhängigkeit vom prozentualen Laststrom I des Nennstromes $I_N$. Daraus ist zu erkennen, daß der prozentuale Fehler nur in drei Punkten den Nullwert erreicht. Die Fehlerkurve wird im Bereich von Lastströmen I << $I_N$ im wesentlichen von der Reibung der Läuferscheibe des Zählers und bei größeren Lastströmen von der sogenannten Stromdämpfung verursacht, die im wesentlichen proportional ist dem Quadrat des Laststromes. Die Stromdämpfung macht sich bei Laststromstärken von etwa 50% des Nennstromes an aufwärts bemerkbar und führt zu einem Anstieg des prozentualen Fehlers bis zu einem Wert des Laststromes von etwa 300% des Nennstromes und fällt dann kontinuierlich ab.

Die Lage dieser Fehlerkurve in bezug auf die Null-Fehler-Gerade läßt sich durch eine in Fig. 2 dargestellte Schaltungsanordnung parallelverschieben. Dazu werden die Spannungseisen 2, 3, 4 eines schematisch dargestellten Drehstrom-Elektrizitätszählers 5 mit Hilfswicklungen 6, 7, 8 versehen. Jede dieser Hilfswicklungen ist an einer Mehrphasen-Gleichrichteranordnung 9 angeschlossen, deren ausgangsseitiger Gleichstromkreis als Kompensationsstromkreis über eine einstellbare elektrische Bürde in Form eines Bürdenwiderstandes 10 und einen dazu parallelgeschalteten Glättungskondensator 11 geschlossen ist. Die Größe des Bürdenwiderstandes 10 ist von einem Steuergerät 12 in Abhängigkeit von dem über die Stromeisen 13, 14, 15 des Elektrizitätszählers 5 von einem Verbraucher 16 aus dem Drehstromnetz RST entnommenen Laststromes I einstellbar. Die Drehzahl der Läuferscheibe 17 des Elektrizitätszählers 5 ist bei konstanter Netzspannung proportional zum Laststrom I und wird von einer Drehzahlmeßeinrichtung 18, wie sie beispielsweise aus der DE-A-34 36 909 bekannt ist, ermittelt und dem Steuergerät 12 als laststromabhängige Steuerimpulsfrequenz P/s = f(I) zugeführt.

In Fig. 3 ist eine Schar von Fehlerkurven $F_1$, $F_2$, $F_3$, $F_4$ mit unterschiedlichen elektrischen Bürden bzw. Kompensationsstromgrößen $I_K$ als Parameter dargestellt. Dabei entspricht die Fehlerkurve $F_1$ der Fehlerkurve 1 aus Fig. 1. Daraus ist zu erkennen, daß die Fehlerkurven bei der Wahl unterschiedlich großer Kompensationsströme $I_K$ eine Parallelverschiebung erfahren. Daraus ergibt sich, daß durch eine entsprechende Wahl der Größe des Kompensationsstromes für jeden einzelnen Wert des Laststromes I ein Null-Fehler-Punkt ermittelt werden kann.

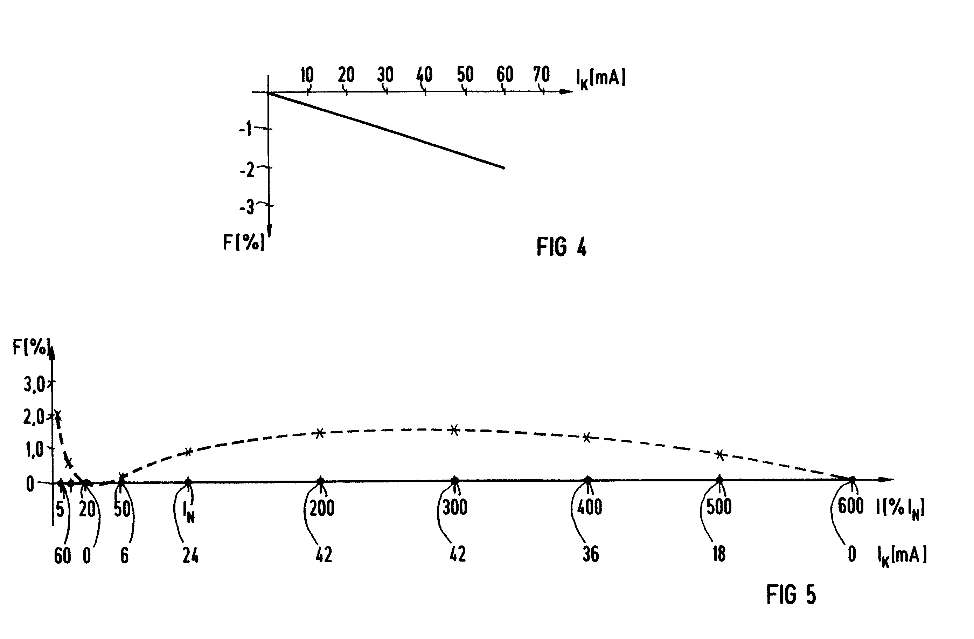

In Fig. 4 ist anhand der Abhängigkeit des prozentualen Fehlers F vom Kompensationsstrom $I_K$ in mA gezeigt, wie hoch der jeweilige Kompensationsstrom sein muß, um bestimmte Fehlergrößen exakt zu kompensieren. Bei richtiger Wahl des Kompensationsstromes ergibt sich die im Diagramm der Fig. 5 dargestellte vollständige Fehlerkompensation, bei der alle angekreuzten, auf der gestrichelt dargestellten Fehlerkurve liegenden Stromwerte des Laststromes I als Punkte auf der Null-Fehler-Geraden liegen.

Voraussetzung für eine solche vollständige Fehlerkompensation ist, daß die Kompensationsstromgrößen in richtiger Weise der Fehlerkurve F zugeordnet werden. Dazu bedarf es zunächst der genauen Ermittlung der individuellen Fehlerkurve eines Zählers und der Einspeicherung der dazu passenden Kompensationsstromgrößen in das Steuergerät 12. Dieses kann mit analogen Mitteln geschehen. Zweckmäßiger ist jedoch eine Ausführungsform in Digitaltechnik. Dazu bietet sich ein Mikrocomputer an, in dessen Speicher die den betreffenden Laststromwerten zugeordneten Kompensationsstromwerte in Form von Software eingegeben und abgespeichert werden. Dadurch besteht die Möglichkeit, mit einer einzigen Hardwarekonfiguration auszukommen, deren Funktion per Software zählerindividuell vorgegeben werden kann. Dabei hängt die Genauigkeit von der Dichte der Kompensationswerte ab.

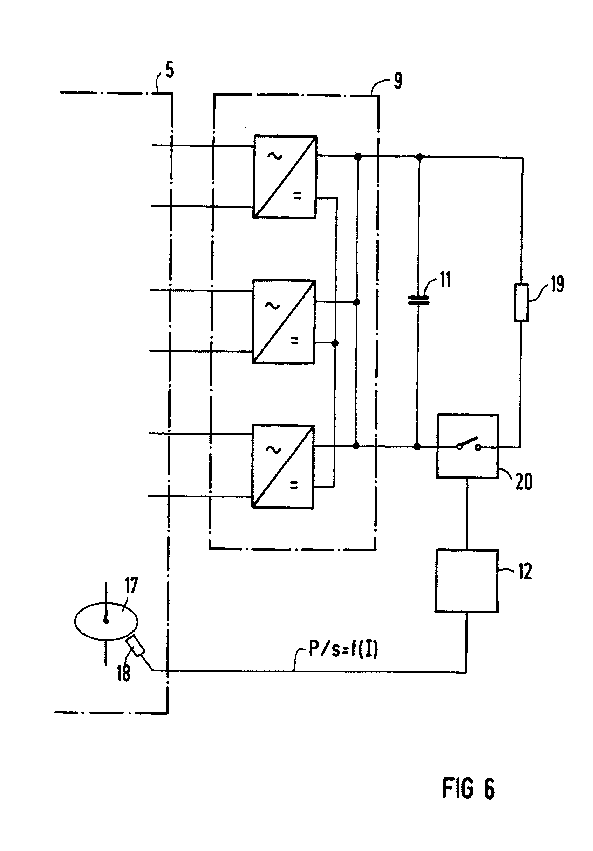

Die Steuerung des Kompensationsstromes $I_K$ kann dann auf unterschiedliche Weise beispielsweise dadurch geschehen, daß die Größe des Bürdenwiderstandes 10 unmittelbar variiert wird oder, wie in Fig. 6 dargestellt, bei konstantem Bürdenwiderstand 19 mit Hilfe eines elektronischen Schalters 20 der Bürdenwiderstand 19 durch Einschaltimpulse unterschiedlich langer, von der Größe der Steuerimpulsfrequenz P/s abhängiger Impuls-Pausen-Dauer in den Fehlerstromkreis eingeschaltet wird.

Eine besonders kostengünstige Ausführungsform ergibt sich dann, wenn dem Elektrizitätszähler nach dem Induktionsprinzip ein elektronisches Tarifgerät zugeordnet ist. Dieses besitzt üblicherweise einen Mikrocomputer, der für den vorgeschriebenen Zweck mitbenutzt werden kann.

## Patentansprüche

1. Fehlerkompensationsanordnung für einen Elektrizitätszähler nach dem Induktionsprinzip mit Spannungseisen und Stromeisen, in deren Luftspalt eine gebremste Läuferscheibe derart angeordnet ist, daß auf diese ein von der dem Netz entnommenen elektrischen Leistung abhängiges Drehmoment ausgeübt wird, so daß die Läuferscheibe mit einer der entnommenen Leistung abhängigen Drehzahl rotiert und ein in kWh geeichtes Zählwerk antreibt, **dadurch gekennzeichnet,** daß die Spannungseisen (2, 3, 4) mit Hilfswicklungen (6, 7, 8) versehen sind, die mit einer zusätzlichen elektrischen Bürde (10, 19) einen Kompensationsstromkreis bilden, dessen Kompensationsstrom ($I_K$) in Abhängigkeit von der Fehlerkurve (1) des Elektrizitätszählers (5) von einem Steuergerät (12) derart einstellbar ist, daß der vom Laststrom (I) abhängige Fehler (F) kompensiert wird.

2. Fehlerkompensationsanordnung nach Anspruch 1, **dadurch gekennzeichnet,** daß bei Verwendung eines Mehrphasen-Elektrizitätszählers (5) die Hilfswicklungen (6, 7, 8) der Spannungseisen (2, 3, 4) über eine Mehrphasen-Gleichrichteranordnung (9) Bestandteil eines geglätteten Gleichstromkreises als Kompensationsstromkreis sind.

3. Fehlerkompensationsanordnung nach Anspruch 1 oder 2, **dadurch gekennzeichnet,** daß als Steuergerät (12) ein Mikrocomputer verwendet ist, dem als von der entnommenen elektrischen Leistung abhängige Steuergröße eine von der Drehzahl der Läuferscheibe (17) abhängige Steuerimpulsfrequenz (P/s) als Funktion des Laststromes (I) zugeführt wird, die dieser in laststromabhängige Größen umrechnet und aus jeder Stromgröße (I) über die in einem Speicher abgelegten Werte der Fehlerkurve (F = f(I)) des angeschlossenen Elektrizitätszählers (5) den zugeordneten Kompensationsstrom ($I_K$) für die Hilfswicklungen (6, 7, 8) berechnet.

4. Fehlerkompensationsanordnung nach Anspruch 3, **dadurch gekennzeichnet,** daß der Kompensationsstromkreis eine konstante elektrische Bürde in Form eines ohmschen Bürdenwiderstandes (19) enthält, der durch vom Mikrocomputer erzeugte Einschaltimpulse unterschiedlicher, von der jeweils ermittelten Steuerspannung $U_S$ abhängiger Impuls-Pausen-Dauer in den Kompensationstromkreis eingeschaltet wird.

5. Fehlerkompensationsanordnung nach Anspruch 3 oder 4, **dadurch gekennzeichnet,** daß bei Vorhandensein eines mit dem Elektrizitätszähler (5) kombinierten elektronischen Tarifgerätes dessen Mikrocomputer zum Zwecke der Fehlerkompensation mitbenutzt ist.

6. Fehlerkompensationsanordnung nach einem der vorhergehenden Ansprüche, **dadurch gekennzeichnet,** daß die elektrische Bürde (10, 19) bei Ein- oder Mehrphasenzählern gleich- oder wechselstromseitig angeordnet ist.

7. Fehlerkompensationsanordnung nach Anspruch 6, **dadurch gekennzeichnet,** daß die elektrische Bürde (10, 19) aus ohmschen Widerständen gebildet ist.

FIG 1

FIG 3

EP 0 456 868 A1

FIG 2

$P/s=f(I)$

EP 0 456 868 A1

EP 0 456 868 A1

FIG 4

FIG 5

FIG 6

**Europäisches Patentamt**

**EUROPÄISCHER RECHERCHENBERICHT**

Nummer der Anmeldung

**EP 90 10 9385**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | US-A-2 412 070 (WAGNER)<br>* Spalte 2, Zeile 55 - Spalte 2, Zeile 15; Spalte 3, Zeilen 3-67; Figur 1 * | 1 | G 01 R 21/133<br>G 01 R 11/21<br>G 01 R 11/23 |
| A | | 6,7 | |
| | – – – | | |
| Y | DE-A-3 514 371 (MITSUBISHI)<br>* Seite 8, Zeilen 10-33; Figuren 2-4 * | 1 | |
| | – – – | | |
| A | WO-A-9 000 740 (SANGAMO WESTON)<br>* Seite 9, Zeile 20 - Seite 10, Zeile 22; Seite 12, Zeile 6 - Seite 13, Zeile 31; Figuren 2,3 * | 1,7 | |
| | – – – | | |
| A | JOURNAL OF PHYSICS E-SCIENTIFIC INSTRUMENTS, Band 14, Nr. 7, Juli 1981, Seiten 777-782; H.M.J.M. DORT-MANS: "Application of microprocessors"<br>* Seite 778, rechte Spalte, Absatz 4 - Seite 779, linke Spalte, letzter Absatz; Figuren 2,3 * | 1,3,5 | |
| | – – – | | |
| A | IEEE TRANSACTIONS ON POWER DELIVERY, Band PWRD-2, Nr. 4, Oktober 1987, Seiten 1018-1024; E. SO: "A current-comparator-based wattmeter for high voltage power measurements at very low power factors"<br>* Zusammenfassung * | 1 | RECHERCHIERTE SACHGEBIETE (Int. Cl.5)<br><br>G 01 R |
| | – – – | | |
| A | DE-A-2 461 259 (SIEMENS)<br>* Seite 2, letzter Absatz - Seite 3, Absatz 1; Figur 1 * | 3 | |
| | – – – – – | | |

Der vorliegende Recherchenbericht wurde für alle Patentansprüche erstellt

| Recherchenort | Abschlußdatum der Recherche | Prüfer |
|---|---|---|
| Den Haag | 25 Januar 91 | SINAPIUS G.H. |